# EUROPÄISCHE PATENTANMELDUNG

(11) **EP 4 307 506 A1**
(43) Veröffentlichungstag der Anmeldung: **17.01.2024**
(21) Anmeldenummer: 23180824.7
(22) Anmeldetag: 22.06.2023
(51) Int. Cl.: H02H 3/16, B60L 3/00, G01R 31/52

(54) **VERFAHREN UND ANORDNUNG ZUM TESTEN EINES ELEKTRISCHEN GLEICHSPANNUNGSNETZES UND AUFFINDEN EINES ERDSCHLUSSES**

(30) Priorität: 23.06.2022 DE 102022206279
(71) Anmelder: Siemens Mobility GmbH, 81739 München (DE)
(72) Erfinder: Schwarzer, Jens Konstantin, 47809 Krefeld (DE); Osterholt, Bernd-Peter, 40237 Düsseldorf (DE)
(74) Vertreter: Siemens Patent Attorneys

(57) **Zusammenfassung**

Bei einem Verfahren zum Testen eines elektrischen Gleichspannungsnetzes auf Vorliegen eines intrinsischen Erdschlusses, bei dem das Gleichspannungsnetz einen ersten Leiter (10) auf einem ersten erdfreien Potential und einen zweiten Leiter (20) auf einem zweiten erdfreien Potential umfasst, sowie eine Last (41) umfasst, die über eine Sicherung (11, 21) mit dem ersten Leiter (10) oder mit dem zweiten Leiter (20) verbunden ist, ist vorgesehen, dass zunächst der erste Leiter (10) mit dem Erdpotential (40) verbunden und wieder getrennt wird, und danach der zweite Leiter (20) mit dem Erdpotential (40) verbunden und wieder getrennt wird, so dass bei einem intrinsischen Erdschluss im Netz die Sicherung auslöst.

## Beschreibung

Die Erfindung betrifft ein Verfahren, mit dem ein potentialfreies Gleichspannungsnetz auf Vorliegen eines Erdschlusses getestet und gegebenenfalls ein solcher lokalisiert werden kann, sowie eine entsprechende Anordnung.

Elektrische Netze können in unterschiedlicher Form ausgeführt werden, insbesondere hinsichtlich ihrer Erdung. Ein Netz, bei dem alle stromführenden Leiter gegen Erde isoliert sind, wird als IT-Netz oder IT-System bezeichnet. Der Begriff "isoliert" umfasst dabei für den Fachmann auch eine sehr hochohmige Verbindung gegen Erde, wobei der erforderliche hochohmige Widerstandswert unter anderem vom Anwendungsfall abhängt. Ein IT-Netz kann insbesondere als Gleichstromnetz ausgeführt sein, dabei ist keiner der Leiter mit dem Erdpotential verbunden. In einem IT-Gleichstromsystem liegen beide Leiter auf einem von Null verschiedenen Potenzial. Mit anderen Worten, die Leiter in einem IT-Netz liegen auf einem erdfreien Potential.

Ein Vorteil eines IT-Systems ist seine erhöhte Zuverlässigkeit: Tritt ein Fehler in Form eines Erdschlusses, d.h. einer niederohmigen Verbindung mit der Erde, auf, ist der Betrieb weiterhin möglich. Als Folge eines einfachen Erdschlusses fließt kein hoher Fehlerstrom, so dass eine vorhandene Sicherung nicht auslöst. Abhängig von den sehr hochohmigen Isolationswiderständen gegen Erde fließt nur ein geringer Fehlerstrom. Erst ein zweifacher Erdschluss führt bei einem IT-System zum Ausfall. IT-Netze werden daher in Anwendungen eingesetzt, die zuverlässig arbeiten müssen und bei denen Abschaltungen mit hohen Risiken verbunden sind, also beispielsweise Krankenhäuser, Industrieanlagen und Fahrzeugen. So wird üblicherweise das Bordnetz von Schienenfahrzeugen als IT-System ausgeführt.

Allerdings ist das Auffinden der Fehlerursache bei einem einfachen Erdschluss aufwändig, insbesondere bei einem ausgedehnten Netz mit einer großen Anzahl von Lasten, oder bei nicht-dauerhaften oder unregelmäßig wiederkehrenden Erdschlüssen. In der Regel wird die Ursache des Erdschlusses durch sukzessives Zuschalten der Lasten in einem langwierigen Prozess gesucht.

Aufgabe der Erfindung ist es, ein Verfahren anzugeben, mit dem ein IT-Gleichspannungsnetz auf Vorliegen eines einfachen Erdschlusses getestet werden kann. Wenn ein solcher Erdschluss aufgetreten ist, soll er einfach und zuverlässig erkannt und lokalisiert werden können. Eine weitere Aufgabe ist die Angabe einer entsprechenden Anordnung.

Diese Aufgaben werden gelöst durch ein Verfahren mit den Merkmalen des Patentanspruchs 1 und durch eine Anordnung gemäß Patentanspruch 5. Vorteilhafte Ausgestaltungen der Erfindung sind in den Unteransprüchen angegeben.

Die Erfindung sieht vor, bei einem IT-Gleichspannungsnetz mit mindestens zwei auf erdfreien Potentialen liegenden Leitern (Versorgungsleitungen) und mindestens einer Last, die über eine Sicherung mit dem ersten Leiter oder dem zweiten Leiter verbunden ist, den ersten Leiter mit dem Erdpotential zu verbinden und wieder zu trennen, und danach den zweiten Leiter mit dem Erdpotential zu verbinden und wieder zu trennen. Es wird also quasi alternierend ein potentialfreier Zustand und ein geerdeter Zustand des IT-Netzes hervorgerufen, wobei im geerdeten Zustand zunächst nur der erste Leiter für einen bestimmten Zeitraum geerdet ist und anschließend nur der zweite Leiter für einen bestimmten Zeitraum geerdet ist. Wenn ein intrinsischer einfacher Erdschluss (also ein zusätzlich zu dem durch das Verfahren erzwungenen Erdschluss) im Netz vorliegt, fließt im geerdeten Zustand ein hoher Fehlerstrom, und je nach Ort des intrinsischen Erdschlusses löst die erste Sicherung beim Schließen des ersten oder des zweiten Schalters aus, so dass der Stromkreis hier unterbrochen wird. Von einem intrinsischen Erdschluss spricht man in der Regel dann, wenn der Widerstand nicht mehr ausreichend hochohmig ist, beispielsweise unterhalb von 2kQ liegt. Liegt der intrinsische Erdschluss an einer Stelle vor, die eine geringere Potentialdifferenz zum ersten Potential als zum zweiten Potential hat, so löst die Sicherung beim Schließen des zweiten Schalters auf, und umgekehrt. Wenn das Netz mehrere Lasten aufweist, löst die einem intrinsischen Erdschluss nächstliegende (im Sinne des geringsten Widerstands) Sicherung aus.

Wenn kein intrinsischer Erdschluss im IT-Gleichspannungsnetz vorliegt, fließt kein erhöhter Fehlerstrom aufgrund der alternierenden erzwungenen Erdschlüsse, und das IT-Netz arbeitet ungestört weiter. Das IT-Netz kann somit auf Vorliegen eines intrinsischen einfachen Erdschlusses getestet werden, und bei vorhandenem Fehler ist dieser einfach erkennbar und lokalisierbar.

Das erfindungsgemäße Gleichspannungsnetz umfasst einen ersten und einen zweiten Leiter, die auf einem ersten bzw. davon verschiedenen zweiten erdfreiem Gleichspannungspotential liegen, sowie eine Last, die über eine Sicherung mit dem ersten Leiter oder dem zweiten Leiter verbunden ist. Der erste und der zweite Leiter stellen Versorgungsleitungen dar. Das Netz umfasst ferner einen ersten Schalter, mit dem der erste Leiter mit dem Erdpotential verbindbar ist, und einen zweiten Schalter, mit dem der zweite Leiter mit dem Erdpotential verbindbar ist.

Gemäß einem Ausführungsbeispiel sind zwei Sicherungen vorgesehen, wobei die Last über die erste Sicherung mit dem ersten Leiter und über die zweite Sicherung mit dem zweiten Leiter verbunden ist. Liegt der intrinsische Erdschluss an einer Stelle vor, die (im fehlerfreien Zustand) eine geringere Potentialdifferenz zum ersten Potential als zum zweiten Potential hat, so löst in der Regel die erste Sicherung beim Schließen des zweiten Schalters auf. Liegt der intrinsische Erdschluss an einer Stelle vor, die (im fehlerfreien Zustand) eine geringere Potentialdifferenz zum zweiten Potential als zum ersten Potential hat, so löst in der Regel die zweite Sicherung beim Schließen des ersten Schalters auf.

Der erste und der zweite Schalter werden je Verwendung des Netzes und den dadurch vorgegebenen Anforderungen ausgewählt. Vorzugsweise werden Schütze eingesetzt, die insbesondere für kleine oder mittlere Lasten kostengünstig verfügbar sind.

Das Testverfahren benötigt nur wenig Zeit, in der Regel im Bereich von Sekunden oder wenigen Minuten. Das Testen kann in bestimmten Zeitintervallen durchgeführt werden. Es kann aber auch anlassbedingt erfolgen, beispielsweise wenn ein in der im Netz vorhandener Isolationswächter eine nicht ausreichende Isolation signalisiert. Isolationswächter sind dem Fachmann bekannte Bauteile, die in IT-Netzen symmetrische oder unsymmetrische Änderungen der Spannungen gegen Erde erkennen.

Gemäß einer Ausführungsform wird das Verfahren für das Bordnetz eines Fahrzeugs, insbesondere eines Schienenfahrzeugs, eingesetzt. Das Bordnetz wird um den ersten und den zweiten Schalter ergänzt. Das Testen des Bordnetzes kann routinemäßig in den Betriebsablauf integriert werden, beispielsweise bei Betriebsbeginn oder -ende.

Die Erfindung wird im Folgenden anhand von Ausführungsbeispielen näher erläutert. Es zeigen in schematischer Darstellung
- Fig.1: ein erstes Ausführungsbeispiel des Gleichspannungs-netzes
- Fig.2: einen Verfahrensablauf

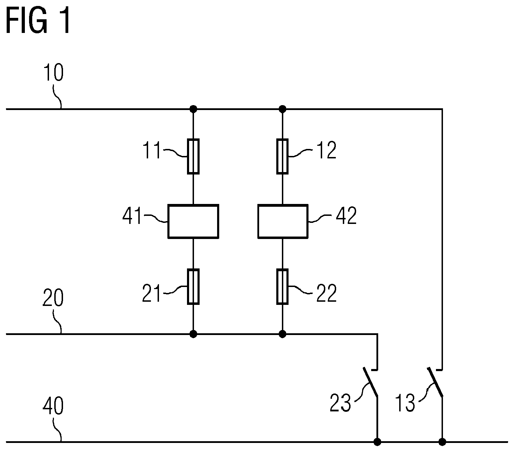

Fig.1 zeigt ein IT-Gleichspannungsnetz mit einem ersten Leiter 10 und einem zweiten Leiter 20. Eine erste Last 41 ist über eine erste Sicherung 11 mit dem ersten Leiter und über eine zweite Sicherung 21 mit dem zweiten Leiter verbunden. Der erste und der zweite Leiter sind an eine Gleichspannungsquelle angeschlossen, die Potentialdifferenz beträgt in diesem Beispiel 110V. Mithilfe eines ersten Schalters 13 ist der erste Leiter 10 mit dem Erdpotential 40 verbindbar, mithilfe eines zweiten Schalters 23 ist der zweite Leiter mit dem Erdpotential 40 verbindbar. Im intakten Zustand des Netzes sind die beiden Leiter bei geöffnetem ersten und zweiten Schalter nicht oder höchstens sehr hochohmig mit dem Erdpotential verbunden, d.h. beide Leiter liegen auf einem erdfreien Potential.

Das Netz umfasst ferner eine zweite Last 42, die über eine Sicherung 12 an den ersten Leiter und eine Sicherung 22 an den zweiten Leiter angeschlossen ist.

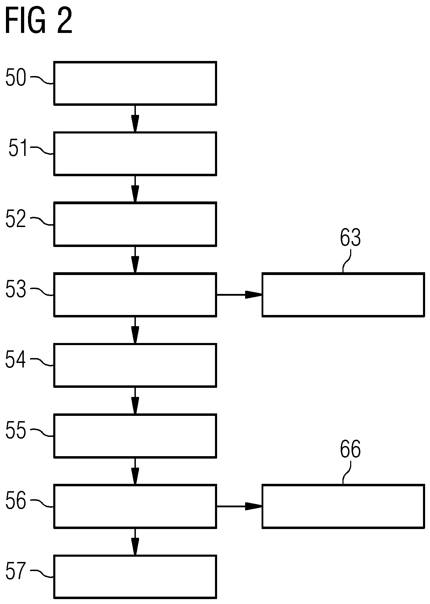

Fig. 2 zeigt den Verfahrensablauf am Beispiel des Gleichspannungsnetzes von Fig.1. Schritt 50 stellt den Beginn des Testverfahrens dar. In Schritt 51 wird der erste Schalter geschlossen, so dass der erste Leiter 10 mit dem Erdpotential verbunden ist, und nach wenigen Sekunden in Schritt 52 wieder geöffnet. In Schritt 53 wird geprüft, ob eine Sicherung im Netz ausgelöst hat. Wenn dies der Fall ist, liegt bei der dieser Sicherung zugeordneten Last ein intrinsischer Erdschluss vor, dies ist in der Figur durch das Testergebnis 63 symbolisiert.

Wenn keine Sicherung ausgelöst hat, wird in Schritt 54 der zweite Schalter geschlossen und nach wenigen Sekunden in Schritt 55 wieder geöffnet, so dass die kurzzeitige Verbindung des zweiten Leiters mit dem Erdpotential wieder gelöst ist. In Schritt 56 wird geprüft, ob eine Sicherung ausgelöst hat. Wenn dies der Fall ist, liegt bei der dieser Sicherung zugeordneten Last ein intrinsischer Erdschluss vor, dies ist in der Figur durch das Testergebnis 66 symbolisiert. Als Beispiel sei angenommen, dass ein intrinsischer Erdschluss am Eingang der ersten Last 41 vorhanden ist, und zwar an deren der Sicherung 11 zugewandten Eingang. Dann löst die erste Sicherung 11 beim Schließen des zweiten Schalters 23 aus. Da diese Sicherung der ersten Last 41 zugeordnet ist, kann die erste Last 41 dadurch als Fehlerursache identifiziert werden.

Wenn andererseits auch beim Schließen des zweiten Schalters 23 keine Sicherung ausgelöst hat, ist in Schritt 57 das Testverfahren abgeschlossen mit dem Ergebnis, dass das Netz keinen intrinsischen Erdschluss aufweist.

Durch das aufeinanderfolgende Schließen und Öffnen der Schalter kann demnach nicht nur das Vorliegen eines intrinsischen Erdschlusses festgestellt werden, sondern auch dessen Ort lokalisiert werden.

Die in den Ausführungsbeispielen beschriebenen Merkmale und Aspekte der Erfindung können selbstverständlich miteinander in unterschiedlicher Weise kombiniert werden. Insbesondere können die Merkmale nicht nur in den beschriebenen Kombinationen, sondern auch in anderen Kombinationen oder für sich genommen verwendet werden.

## Patentansprüche

1. Verfahren zum Testen eines elektrischen Gleichspannungsnetzes auf Vorliegen eines intrinsischen Erdschlusses, bei dem das Gleichspannungsnetz
- einen ersten Leiter (10) auf einem ersten erdfreien Gleichspannungspotential und einen zweiten Leiter (20) auf einem zweiten erdfreien Gleichspannungspotential umfasst,
- eine Last (41) umfasst, die über eine Sicherung (11, 21) mit dem ersten Leiter (10) oder mit dem zweiten Leiter (20) verbunden ist,
- wobei der erste Leiter (10) mit dem Erdpotential (40) verbunden und wieder getrennt wird, und danach der zweite Leiter (20) mit dem Erdpotential (40) verbunden und wieder getrennt wird, so dass bei einem intrinsischen Erdschluss im Gleichspannungsnetz die Sicherung (11, 21) auslöst.

2. Verfahren nach dem vorhergehenden Anspruch, **dadurch gekennzeichnet, dass** die Last (41) über eine erste Sicherung (11) mit dem ersten Leiter (10) und über eine zweite Sicherung (21) mit dem zweiten Leiter (20) verbunden ist.

3. Verfahren nach einem der vorherigen Ansprüche, **dadurch gekennzeichnet, dass** das Verfahren bei einem Bordnetz eines Fahrzeugs, insbesondere eines Schienenfahrzeugs, durchgeführt wird.

4. Verfahren nach einem der vorherigen Ansprüche, **dadurch gekennzeichnet, dass** das Verfahren durchgeführt wird, wenn ein im Gleichspannungsnetz vorhandener Isolationswächter (43) einen nicht ausreichend hohen Widerstand signalisiert.

5. Elektrisches Gleichspannungsnetz mit
- Einem ersten Leiter (10) auf einem ersten erdfreien Gleichspannungspotential,
- einem zweiten Leiter (20) auf einem zweiten erdfreien Gleichspannungspotential,
- einer Last (41), die über eine Sicherung (11, 21) mit dem ersten Leiter oder mit dem zweiten Leiter verbunden ist,
- einem ersten Schalter (13), über den der erste Leiter (10) mit einem Erdpotential (40) verbindbar ist,
- einem zweiten Schalter (23), über den der zweite Leiter (20) mit dem Erdpotential (40) verbindbar ist.

6. Gleichspannungsnetznach dem vorhergehenden Anspruch, **dadurch gekennzeichnet, dass** die Last (41) über eine erste Sicherung (11) mit dem ersten Leiter und über eine zweite Sicherung (21) mit dem zweiten Leiter verbunden ist.

7. Gleichspannungsnetznach einem der vorherigen Ansprüche, **dadurch gekennzeichnet, dass** die das Gleichspannungsnetz ein Bordnetz eines Fahrzeugs, insbesondere eines Schienenfahrzeugs, ist.

8. Gleichspannungsnetznach einem der vorherigen Ansprüche, **dadurch gekennzeichnet, dass** das Gleichspannungsnetz einen Isolationswächter (43) umfasst.
